# EUROPÄISCHE PATENTSCHRIFT

(11) **EP 3 574 297 B1**
(45) Veröffentlichungstag und Bekanntmachung des Hinweises auf die Patenterteilung: **15.09.2021**
(21) Anmeldenummer: 18703469.9
(22) Anmeldetag: 26.01.2018
(51) Int. Cl.: G01L 1/12

(54) **MAGNETISCHER KRAFTSENSOR UND DESSEN HERSTELLUNG**
MAGNETIC FORCE SENSOR AND PRODUCTION THEREOF
CAPTEUR DE FORCE MAGNÉTIQUE ET SA FABRICATION

(30) Priorität: 27.01.2017 AT 500572017
(43) Veröffentlichungstag der Anmeldung: 04.12.2019
(73) Patentinhaber: RENA Technologies Austria GmbH, 2552 Hirtenberg (AT)
(72) Erfinder: HANSAL, Wolfgang, 2753 Markt Piesting (AT); HANSAL, Selma, 2753 Markt Piesting (AT); MANN, Rudolf, 1140 Wien (AT); HALMDIENST, Martina, 2620 Natschbach (AT)
(74) Vertreter: Schwarz & Partner Patentanwälte OG
(86) Internationale Anmeldenummer: PCT/AT2018/060025
(87) Internationale Veröffentlichungsnummer: WO 2018/136988

(56) Entgegenhaltungen:
- EP-A2- 0 012 325
- WO-A1-2012/116933
- DE-A1- 10 023 838
- GB-A- 872 887

## Beschreibung

Die Erfindung betrifft einen magnetischen Kraftsensor mit zumindest einer Leiterbahn aus weichmagnetischem Material, wobei die zumindest eine Leiterbahn zumindest eine Unterbrechung mit einem Abstand aufweist, sowie ein Herstellungsverfahren zur Herstellung des magnetischen Kraftsensors.

Die Messung von physikalischen Größen an Bauteilen von beispielsweise Fahr- und Flugzeugen, Maschinen oder Gebäuden ist ein wesentlicher Punkt bei deren Wartung und Betriebsüberwachung. Eine wichtige Größe ist hierbei die an einem Bauteil wirkende Kraft, deren Messung wichtige Informationen über die Belastung oder den Gesamtzustand des Bauteils liefert.

Die derzeit am häufigsten verwendete Methode ist die Messung von Deformationen und den hierbei auftretenden Kräften mittels Dehnmessstreifen, die an entsprechenden Punkten des Bauteils angebracht sind. Ein wesentlicher Nachteil dieses Systems liegt darin, dass diese Dehnmessstreifen auf dem zu messenden Bauteil aufgeklebt sind, wobei diese Klebung die Übertragung der Messinformation beeinträchtigt und möglicherweise verfälscht. Des Weiteren muss der Dehnmessstreifen elektrisch kontaktiert werden, um die Messinformation auslesen zu können, wobei es bei metallischen Bauteilen notwendig ist, den elektrischen Messkreis vollständig vom Bauteil zu isolieren.

Es sind daher Methoden bekannt geworden, bei welchen die Messung von Deformationen eines Bauteils auf magnetischem Weg erfolgt.

So beschreibt die DE 10 2014 200 461 A1 eine Anordnung zum Messen einer Kraft oder eines Drehmoments an einem Maschinenelement mit einer Permanentmagnetisierung entlang eines geschlossenen Magnetisierungspfades. Hierbei ist ein Magnetfeldsensor vorgesehen, der eine Änderung des Magnetfeldes überwacht. Diese Anordnung ist nicht für alle Bauteile geeignet, weil sie eine Permanentmagnetisierung des Bauteils zumindest in einem bestimmten Bereich erfordert. Auch ist sie störungsanfällig im Hinblick auf magnetische und/oder elektrische bzw. elektromagnetische Einflüsse von außen.

In der DE 36 24 846 A1 eine Vorrichtung zum berührungsfreien Messen einer mechanische Spannung, insbesondere zum Messen der Torsion oder Biegekraft eines Messobjekts beschrieben. Hierzu sind auf einer Welle zwei Bereiche mit einer Schicht aus magnetoelastischem Material angeordnet, das ein unter einem Winkel von 45° ausgebildetes Streifenmuster aufweist. Eine Änderung dieses Schichtmusters bei mechanischer Beanspruchung der Welle wird mittels einer komplizierten Auswerteschaltung überwacht.

Ein weiterer magnetoelastischer Drehmoment-Sensor kann auch der DE 103 31 128 A1 entnommen werden.

Die US 5,036,236 A offenbart einen Näherungssensor basierend auf magnetischen Feldern, wobei der Sensor einen Magnetleiter mit einer Unterbrechung aufweist, die als Referenz für den Abstand zwischen zwei sich zueinander bewegenden Bauteilen aus magnetischem Material dient.

GB 872 887 A offenbart einen magnetischen Kraftsensor mit einer Leiterbahn, welche eine Unterbrechung mit einem Abstand aufweist.

WO 2012/116933 A1 zeigt eine Magnetfeld-Messanordnung mit einer Mehrzahl von Magnetfeldsensoren sowie gekoppelten Magnetflusskonzentratoren. Zumindest zwei dieser Magnetflusskonzentratoren aus weichmagnetischem Material, welche hintereinander angeordnet sind, weisen einen Spalt auf, in welchem ein Magnetfeldsensor angeordnet ist.

DE10023838 offenbart einen magnetischen Kraftsensor mit den Merkmalen des Oberbegriffs des Anspruchs 1.

Die oben angeführten Anordnungen sind für die Überwachung von Deformationsprozessen an einem Bauteil nur teilweise oder gar nicht geeignet, oder weisen einen komplizierten in der Praxis nur wenig geeigneten Aufbau auf.

Es ist daher Aufgabe der Erfindung, einen magnetischen Kraftsensor zur Verfügung zu stellen, der für die Überwachung von Deformationsprozessen auf einem Bauteil auch aus nichtmagnetischem Material geeignet ist, wobei der Sensor an beliebigen Stellen des zu überwachenden Bauteils angeordnet werden kann.

Diese Aufgabe wird erfindungsgemäß gelöst durch einen magnetischen Kraftsensor mit zumindest einer Leiterbahn aus weichmagnetischem Material, wobei die zumindest eine Leiterbahn zumindest eine Unterbrechung mit einem Abstand aufweist, wobei zumindest eine Messeinrichtung zur Überwachung des magnetischen Flusses innerhalb der zumindest einen Leiterbahn vorgesehen ist, wobei der Kraftsensor auf einem Substrat, insbesondere einem zu überwachenden Bauteil, angeordnet ist und eine Änderung des Abstands anhand einer Änderung des magnetischen Flusses in der zumindest einen magnetischen Leiterbahn überwacht ist, wobei die zumindest eine magnetische Leiterbahn mit der zumindest einen Unterbrechung und die zumindest eine Messeinrichtung einen magnetischen Messkreis bilden, wobei zumindest ein Erregermagnet vorgesehen ist, wobei der zumindest eine Erregermagnet als Teil des magnetischen Messkreises ausgebildet ist.

Hierbei wird der magnetische Fluss in der zumindest einen magnetischen Leiterbahn überwacht, wobei eine Änderung des Abstands der zumindest einen magnetische Leiterbahn eine Änderung des magnetischen Flusses in der zumindest einen magnetische Leiterbahn bewirkt. Bei einer allfälligen Deformation des zu überwachenden Bauteils aufgrund von auf ihn wirkenden Kräften verändert sich der Abstand der zumindest einen Unterbrechung der zumindest einen magnetischen Leiterbahn. Damit ändert sich jedoch das in der Unterbrechung der zumindest einen magnetischen Leiterbahn induzierte Magnetfeld, wodurch sich wiederum der magnetische Fluss in der zumindest einen magnetische Leiterbahn ändert. Diese Änderung des magnetischen Flusses ist somit ein Indikator für eine Deformation des zu überwachenden Bauteils.

Als Messmethoden für eine Änderung des magnetischen Flusses können unterschiedliche Verfahren zum Einsatz kommen, nämlich induktiv, nach dem Fluxgate-Prinzip, über den anisotropen magnetischen Widerstand oder mittels Magnetoimpedanz.

Wird die Messung der Flussänderung induktiv durchgeführt, so können in diesem Fall schnelle Flussänderungen gemessen werden, wobei diese Methode unempfindlich gegen langsam, schleichend auftretende Änderungen ist. Des Weiteren können mit dieser Methode keine absoluten Magnetflusswerte ermittelt werden.

Beim anisotropen magnetorestistiven Effekt ändert sich der elektrische Widerstand eines ferromagnetischen Materials mit dessen Magnetisierung, wobei diese Widerstandsänderung gemessen werden kann.

Der Magnetoimpedanz-Effekt beruht einerseits auf der Änderung der differenziellen Permeabilität eines weichmagnetischen Stoffes in Abhängigkeit von dessen Magnetisierung, sowie auf dem sogenannten Skin-Effekt, bei dem der Strom in einem Leiter bei hohen Frequenzen durch das eigene Magnetfeld zur Oberfläche gedrückt wird. Gemeinsam bewirken diese Effekte, dass der Wechselstromwiderstand eines weichmagnetischen Leiters stark von einem äußeren Magnetfeld abhängig ist; dieser für Effekt ist bei Frequenzen im MHz-Bereich besonders gut zu beobachten.

Fluxgate-Sensoren können kleine magnetische Flüsse genau messen, wobei diese Art der Messung aufwendiger ist, weil hierzu die Messstrecken mit Spulen umgeben sein müssen.

Jede dieser Messmethoden ist geeignet, die Änderung des Abstands der zumindest einen Unterbrechung in der zumindest einen Leiterbahn des magnetischen Messkreises zu detektieren.

Bevorzugterweise wird der gemessene Wert für den magnetischen Fluss in einer Auswerteeinheit permanent mit einem vorgebbaren Schwellwert verglichen, und bei Erreichen dieses Schwellwerts ein Signal ausgegeben. Dieses Signal dient als Warnsignal, wenn sich der zu überwachende Bauteil verformt, wodurch die Änderung des Abstands der zumindest einen Unterbrechung in der magnetischen Leiterbahn hervorgerufen wird.

Erfindungsgemäß ist vorgesehen, dass in einer ersten Ausführung der Erfindung das Substrat aus einem isolierenden Material, beispielsweise Kunststoff, Keramik, Glas, Saphir oder Glimmer besteht. Der erfindungsgemäße Kraftsensor ist hierbei beispielsweise mittels galvanischer Abscheidung auf diesem Substrat aufgebracht, das wiederum auf dem zu messenden Bauteil angeordnet wird.

Alternativ hierzu ist in einer besonders bevorzugten Variante vorgesehen, dass der Kraftsensor direkt auf dem Bauteil, insbesondere mittels galvanischer Abscheidung aufgebracht ist. In diesem Fall kann vorgesehen sein, dass der Kraftsensor über eine magnetische Sperrschicht aus nichtmagnetischem Material verfügt, um den erfindungsgemäßen Kraftsensor gegenüber einem magnetisierbaren Bauteil zu isolieren und damit diesen gegenüber Störeinflüssen zu schützen.

Um in dem Kraftsensor einen Magnetfluss herzustellen, ist zumindest ein Erregermagnet vorgesehen. Dieser Magnet kann ein Permanentmagnet sein, der vorzugsweise ebenfalls mittels galvanischer Abscheidung hergestellt wird. Hierzu wird eine hartmagnetische Legierung abgeschieden oder es können auch permanentmagnetische Partikel in einer nichtmagnetischen Matrix eingelagert sein. Alternativ hierzu kann der Erregermagnet auch ein Elektromagnet sein.

Es ist vorgesehen, dass der magnetische Fluss in der zumindest einen Leiterbahn durch den zumindest einen Erregermagnet, der bevorzugterweise in unmittelbarem Kontakt mit der zumindest einen magnetischen Leiterbahn steht, induziert wird. Alternativ hierzu kann jedoch der zumindest eine Erregermagnet auch außerhalb des Kraftsensors, beispielsweise als Teil des zu überwachenden Bauteils oder als zusätzliches Element im Bereich des zu überwachenden Bauteils ausgebildet sein.

Der erfindungsgemäße Kraftsensor verfügt bevorzugterweise über zumindest eine Messeinrichtung zur Überwachung des magnetischen Flusses innerhalb der zumindest einen Leiterbahn. Auf diese Weise wird ein integraler Messsensor erhalten, ohne dass eine zusätzliche externe Messeinheit erforderlich ist.

Besonders bevorzugt ist hierbei vorgesehen, dass die zumindest eine Messeinrichtung als Messchip mit zumindest einer, vorzugsweise zwei internen magnetischen Messstrecken ausgebildet ist, wobei der Messchip vorzugsweise auf einem elektrisch isolierenden Träger, beispielsweise Kunststoff, Keramik, Glas, Saphir oder Glimmer angeordnet ist. Dieser Messchip wertet die Magnetflussänderungen aus und leitet die erhaltenen Daten an eine (externe) Auswerteeinheit weiter.

In einer besonders bevorzugten Ausführung der Erfindung ist vorgesehen, dass die zumindest eine magnetische Leiterbahn mit der zumindest einen Unterbrechung und die zumindest eine Messeinrichtung einen magnetischen Messkreis bilden. Vorteilhafterweise ist hierbei der zumindest eine Erregermagnet ebenfalls Teil dieses magnetischen Messkreises. Alternativ kann der zumindest eine Erregermagnet außerhalb des Kraftsensors angeordnet sein.

In störanfälligen Umgebungen kann es erforderlich sein, externe Effekte wie Streufelder oder Temperaturschwankungen, die den magnetischen Fluss unabhängig von einer Krafteinwirkung beeinflussen, zu kompensieren. Zu diesem Zweck ist ein zweiter magnetischer Kreis, nämlich ein magnetischer Kompensationskreis mit vorzugsweise zumindest einem weiteren Erregermagneten vorgesehen. Die Anpassung des magnetischen Widerstands des Kompensationskreises kann wahlweise durch Beeinflussung der Permeabilität des magnetischen Leiters während der Herstellung, nämlich der Abscheidung durch beispielsweise Variation des für die Abscheidung verwendeten Pulsmusters, durch geometrische Variationen wie Schichtdicke und/oder Leiterbreite, durch Einbringung einer zusätzlichen Unterbrechung des magnetischen Leiters des Kompensationskreises an einer geeigneten Stelle oder durch eine Kombination dieser Maßnahmen erreicht werden.

Die zumindest eine Messeinrichtung, insbesondere der Messchip verbindet die beiden magnetischen Kreise, nämlich den zumindest einen Messkreis und den zumindest einen Kompensationskreis bevorzugterweise über eine Wheatstone-Brücke. Durch diesen Aufbau können bereits kleinste Änderungen im Magnetfluss genau gemessen werden.

Der erfindungsgemäße Kraftsensor wird insbesondere für die Bestimmung von Deformationen von Bauteilen verwendet.

Die Herstellung des erfindungsgemäßen Kraftsensors erfolgt mittels eines Herstellungsverfahrens, bei dem auf einem Substrat, vorzugsweise auf einem zu überwachenden Bauteil, zumindest eine magnetische Leiterbahn mit zumindest einer Unterbrechung mit einem Abstand aufgebracht wird, wobei die Aufbringung mittels galvanischer Abscheidung erfolgt.

Hierbei wird auf galvanischem Weg eine weichmagnetische Legierung, beispielsweise eine Nickel-Eisen-Legierung mit optimierte Zusammensetzung auf ein vorzugsweise nichtmagnetisches, gegebenenfalls maskiertes Bauteil aufgebracht. Hierbei ist die für die Messung erforderliche Unterbrechung mit einem definierten Abstand entweder bereits in der Maskierung angelegt oder wird nach der Beschichtung beispielsweise mit einem Laser eingearbeitet.

Ist der Untergrund, auf dem der Kraftsensor aufgebracht wird, magnetisch, beispielsweise aus Stahl oder Gusseisen, so muss vor Aufbringung der Leiterbahnen eine nichtmagnetische Schicht auf das Grundmaterial aufgebracht werden. Diese nichtmagnetische Schicht ist beispielsweise eine ebenfalls galvanisch erzeugte Schicht aus Kupfer, Zinn, Zink oder eine Legierung aus zwei oder mehr dieser Elemente oder aber auch aus einer nichtmagnetischen Legierung von Eisenmetallen mit Phosphor. Durch diesen vollmetallischen Aufbau wird eine optimale Anbindung des Sensors an das Bauteil erhalten, ohne dass beispielsweise eine zusätzliche Klebeschicht zur Aufbringung des Sensors auf den zu messenden Bauteil die Messergebnisse beeinflussen kann.

Die galvanische Herstellung der Erregermagneten, die für den erfindungsgemäßen Kraftsensor besonders geeignet sind, kann auf zwei unterschiedliche Weisen erfolgen.

In einer Variante wird eine permanentmagnetischen Legierung, die aus einer Gruppe ausgewählt ist, die Legierungen wie Kobalt-Nickel-Phosphor, Kobalt-Nickel-Mangan-Phosphor, Kobalt-Nickel-Rhenium-Phosphor, Eisen-Platin, Kobalt-Platin und Bismut-Mangan enthält, galvanisch auf dem Substrat bzw. Bauteil abgeschieden.

Alternativ hierzu werden während der galvanischen Abscheidung auf dem Substrat, insbesondere dem Bauteil, in eine nichtmagnetische, metallische Matrix permanentmagnetischen Mikro- oder Nanopartikel eingebaut. Als Partikel kommen hierbei alle hartmagnetischen Materialien in Betracht, ebenso wie hartmagnetische Legierungen in geeigneter Form, beispielsweise als Nanowires, als Pulver wie beispielsweise Ferrite, Chromdioxid, Eisenoxid, Neodym-Eisen-Bor-Pulver oder Kobalt-Samarium-Pulver. Diese Partikel können entweder in Reinform oder nach geeigneter chemischer Oberflächenmodifikation, beispielsweise mit Siloxanen eingesetzt werden. Die chemische Modifikation der Oberfläche der Partikel dient einerseits der Steuerung der Einbaurate der Partikel in die galvanische Schicht, andererseits kann damit die chemische Stabilität gegen den für die Abscheidung verwendeten Elektrolyten erhöht werden.

Bevorzugterweise erfolgte Abscheidung der permanentmagnetischen Schicht in einem von außen angelegten Magnetfeld, das die Partikel in deren Magnetisierungsrichtung ausrichtet und so die resultierende Feldstärke des galvanisch abgeschiedenen Permanentmagneten erhöht.

Für spezielle Anforderungen ist es möglich, die Abscheidung der permanentmagnetischen Schicht in mehreren Phasen durchzuführen und die Richtung des äußeren Magnetfeldes zwischen den Phasen zu verändern. Hierdurch lassen sich permanentmagnetische Schichten mit örtlich variierender Magnetisierung erzeugen.

Im Folgenden wird anhand von nicht-einschränkenden Ausführungsbeispielen mit zugehörigen Figuren die Erfindung näher erläutert. Hierin zeigen:
- Fig. 1: eine schematische Ansicht einer ersten Ausführung des erfindungsgemäßen Kraftsensors;
- Fig. 2: eine Detailansicht der magnetischen Leiterbahn des Kraftsensors aus Fig. 1;
- Fig. 3: eine Detailansicht des Messchips aus Fig. 1;
- Fig. 4: eine schematische Darstellung des Schichtaufbaus des Kraftsensors aus Fig. 1; und
- Fig. 5: eine schematische Ansicht einer zweiten Ausführung des erfindungsgemäßen Kraftsensors.

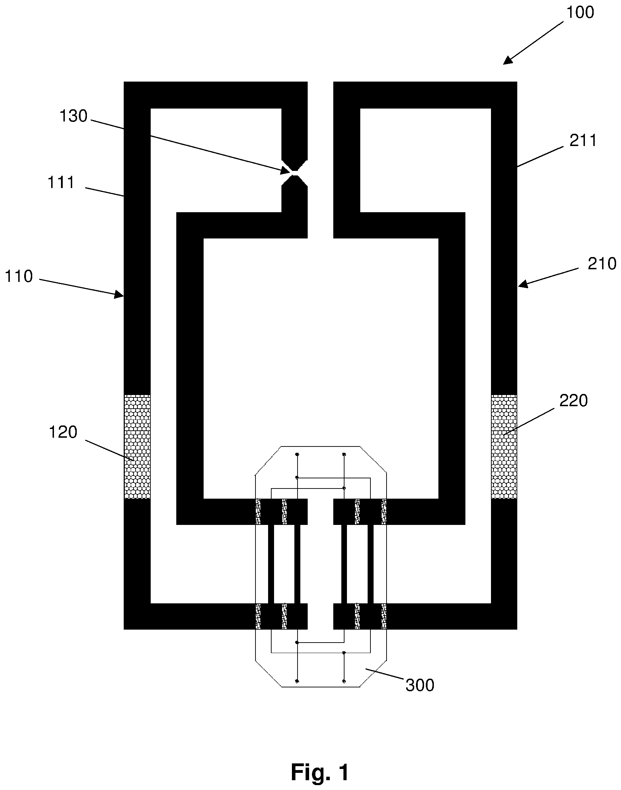

In der Fig. 1 ist eine erste, besonders bevorzugte Ausführung des erfindungsgemäßen Kraftsensors 100 dargestellt. Dieser Kraftsensor 100 weist einen magnetischen Messkreis 110 mit einer magnetischen Leiterbahn 111 auf, in der ein erster Erregermagnet 120 angeordnet ist.

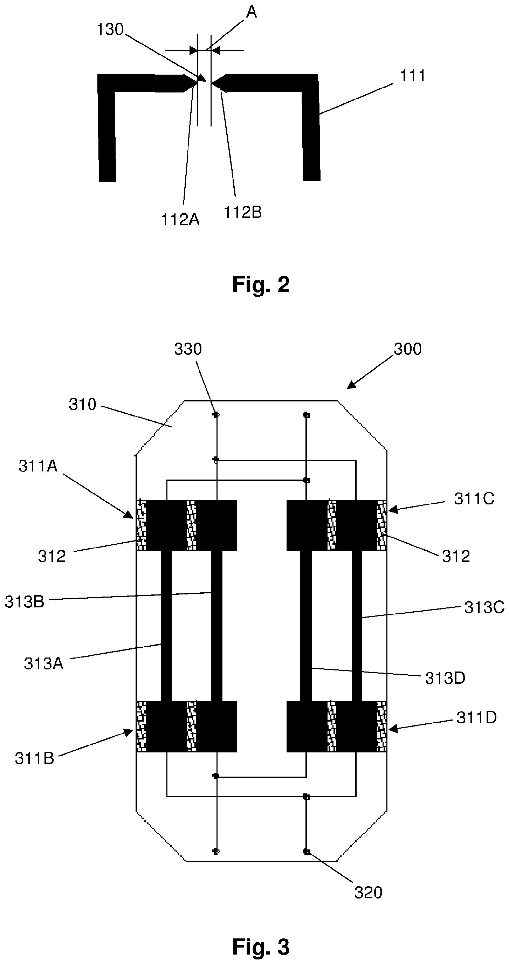

Diese magnetische Leiterbahn 111 weist eine Unterbrechung 130 auf, wobei die beiden Enden der magnetischen Leiterbahn 112A, 112B in einem Abstand A zueinander angeordnet sind, und sich ihre beiden Enden 112A, 112B in ihrem Querschnitt verjüngen (siehe Fig. 2). Durch diese spitzen- oder pfeilförmige Ausbildung der beiden Enden 112A, 112B der magnetischen Leiterbahn 111 werden in diesem Bereich besonders starke Magnetfeldlinien aufgebaut, wodurch eine genauere Messung einer allfälligen Änderung des Abstands A der beiden Enden 112A, 112B zueinander und damit einer allfälligen Änderung des Magnetfelds zwischen den beiden Enden 112A, 112B ermöglicht wird.

Um Einflüsse, insbesondere magnetische und/oder elektromagnetische Einflüsse aus der Umgebung zu minimieren, weist der erfindungsgemäße Kraftsensor 100 in dieser Ausführung der Erfindung zusätzlich einen Kompensationsmesskreis 210 mit einer magnetischen Leiterbahn 211 auf, der ebenfalls über einen zweiten Erregermagneten 220 verfügt. Die magnetischen Flüsse der beiden magnetisch wirksamen Messkreise 110, 210 werden über einen Messchip 300 gegeneinander gemessen.

Dieser Messchip 300 ist in der Fig. 3 detailliert abgebildet. Dieser ist auf einer elektrisch isolierenden Basis 310 aufgebracht, um ihn gegenüber dem metallischen Untergrund, nämlich dem zu überwachenden Bauteil elektrisch zu isolieren. Diese elektrisch isolierende Basis 310 ist beispielsweise aus Keramik, Kunststoff, Glimmer oder ähnlichen isolierenden Materialien hergestellt.

Der magnetische Leiter 111 des magnetischen Messkreises 110 koppelt mit seinen beiden zweiten Enden an die beiden magnetischen Eingänge 311A, 311B des Messchips 300 an. Hierzu weisen die beiden Eingänge 311A, 311B eine magnetische Ankopplung mittels Ferrit 312 bei gleichzeitiger elektrischer Isolierung auf. Zwischen den beiden Eingängen 311A, 311B sind zwei magnetische Messstrecken 313A, 313B vorgesehen, die der Überwachung der Unterbrechung 130 mit dem Abstand A des magnetischen Leiters 111 dienen.

Auch für den Kompensationskreis 210 sind magnetische Eingänge 311C, 311D am Messchip 300 vorgesehen, die wiederum über zwei Messstrecken 313C, 313D miteinander in Verbindung stehen.

Schließlich sind noch Anschlüsse 320 für die Versorgung des Messchips 300 mit elektrischem Strom sowie Signalausgänge 330 zur Auswertung der erhaltenen Messsignale vorgesehen.

Die Funktionsweise des erfindungsgemäßen Kraftsensors 100 lässt sich wie folgt beschreiben:
Während der Überwachung eines Bauteils, auf dem der Kraftsensor 100 aufgebracht ist, weisen sowohl der magnetische Messkreis 110 als auch der Kompensationskreis 210 ein konstantes magnetisches Feld auf. Tritt jedoch eine Deformation des Bauteils im Bereich der Unterbrechung 130 des magnetischen Messkreises 110 auf, so ändert sich der Abstand A der Unterbrechung 130 und damit das induzierte magnetische Feld, wobei die daraus resultierende Änderung des magnetischen Flusses in den Messkreisen 110, 210 über die Messstrecken 313A, 313B, 313C, 313D detektiert wird. In einer entsprechenden Auswerteelektronik (nicht dargestellt) kann diese Änderung des magnetischen Flusses analysiert werden und gegebenenfalls beispielsweise eine Warnung hinsichtlich der Stabilität des Bauteils ausgegeben werden.

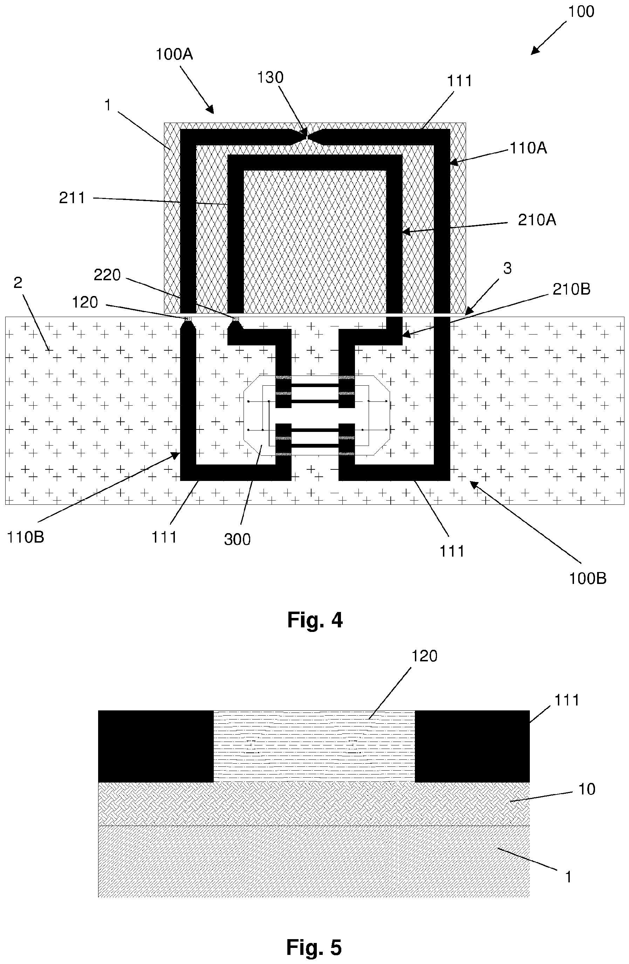

In der Fig. 4 ist eine weitere Ausführungsform des erfindungsgemäßen Kraftsensors 100 dargestellt. Hierbei ist der Kraftsensor 100 zweiteilig aufgebaut, wobei ein erster Teil, der Überwachungsteil 100A auf einem zu überwachenden Bauteil 1 angeordnet ist. Ein zweiter Teil, der Messteil 100B des Kraftsensors 100 ist auf einem vom ersten Bauteil 1 über einen Spalt 3 beabstandeten zweiten Bauteil 2 angeordnet.

Der außenliegende magnetische Messkreis 110 liegt mit einem ersten Teil 110A, dessen magnetische Leiterbahn 111 die Unterbrechung 130 aufweist, auf dem zu überwachenden Bauteil 1, während sein zweiter Teil 110B mit einem Erregermagneten 120 auf dem Bauteil 2 angeordnet ist. Ebenso ist der innenliegende magnetische Kompensationskreis 210 zweiteilig, nämlich mit einem ersten Teil 210A auf dem ersten Bauteil 1 und mit seinem zweiten Teil 210B mit seiner Leiterbahn 211 auf dem zweiten Bauteil 2 angeordnet ist, aufgebaut. Die Leiterbahnen 111, 211 enden jeweils in dem Messchip 300.

Dieser zweiteilige Aufbau des erfindungsgemäßen Kraftsensors 100 mit zwei Unterbrechungen, nämlich der Unterbrechung 130 der magnetischen Leiterbahn 111 sowie dem Spalt 3, über zwei Bauteile 1, 2 hinweg erlaubt eine allfällige Deformierung des ersten Bauteils 1 zu überwachen. Hierbei ändert sich, wie schon bereits zuvor beschrieben, bei einer Deformation des ersten Bauteils 1 der Abstand A in der Unterbrechung 130 und damit der magnetische Fluss innerhalb des Kraftsensors 100. Gleichzeitig wird aber auch die relative Position der beiden Bauteile 1, 2 zueinander überwacht. Da die beiden Erregermagneten 120, 220 auf dem zweiten Bauteil 2 in unmittelbarer Nähe zu den Leiterbahnen 111, 112 auf dem ersten Bauteil 1 angeordnet sind, verändert sich wiederum der magnetische Fluss, wenn sich der Spalt 3 zwischen den beiden Bauteilen 1, 2 vergrößert oder verkleinert, oder aber sich die Position des ersten Bauteils 1 in Relation zu dem zweiten Bauteil 2 verschiebt, ohne dass sich ihr Abstand zueinander verändert.

Ist der zu überwachende Bauteil 1 aus einem magnetischen Material hergestellt, so ist es erforderlich, den magnetischen Messkreis 110 sowie gegebenenfalls den Kompensationskreis 210 isoliert auf diesem Bauteil 1 aufzubringen. Hierzu ist in einer weiteren Ausführung der Erfindung - wie in Fig. 5 dargestellt - vorgesehen, dass eine nichtmagnetische Isolierungsschicht 10 aus beispielsweise Kupfer, Zinn, Zink oder einer Legierung aus diesen Elementen, aber auch einer nichtmagnetischen Legierung von Eisenmetallen mit Phosphor mittels galvanischer Verfahren aufgebracht wird. Auf diese nichtmagnetische Schicht 10 wird anschließend der magnetische Messkreis 110 mit zugehörigem Erregermagneten 120 ebenfalls galvanisch abgeschieden.

## Patentansprüche

1. Magnetischer Kraftsensor (100) mit zumindest einer Leiterbahn (111, 211) aus weichmagnetischem Material, wobei die zumindest eine Leiterbahn (111, 211) zumindest eine Unterbrechung (130) mit einem Abstand (A) aufweist, wobei zumindest eine Messeinrichtung zur Überwachung des magnetischen Flusses innerhalb der zumindest einen Leiterbahn (111, 211) vorgesehen ist, wobei der Kraftsensor (100) auf einem Substrat, insbesondere einem zu überwachenden Bauteil (1, 2), angeordnet ist und eine Änderung des Abstands (A) anhand einer Änderung des magnetischen Flusses in der zumindest einen magnetischen Leiterbahn (111, 211) überwacht ist, **dadurch gekennzeichnet, dass** auf einem Substrat, vorzugsweise auf einem zu überwachenden Bauteil (1, 2), zumindest eine magnetische Leiterbahn (111, 211) aufgebracht wird und die zumindest eine magnetische Leiterbahn (111) mit der zumindest einen Unterbrechung (130) und die zumindest eine Messeinrichtung einen magnetischen Messkreis (110) bilden, wobei zumindest ein Erregermagnet (120, 220) vorgesehen ist, wobei der zumindest eine Erregermagnet (120) als Teil des magnetischen Messkreises (110) ausgebildet ist.

2. Kraftsensor (100) nach Anspruch 1, **dadurch gekennzeichnet, dass** eine magnetische Sperrschicht (10) aus nichtmagnetischem Material vorgesehen ist.

3. Kraftsensor (100) nach Anspruch 1 oder 2, **dadurch gekennzeichnet, dass** zumindest ein Erregermagnet (120, 220) vorgesehen ist, der ein Permanentmagnet, beispielsweise aus einer hartmagnetischen Legierung oder eine nichtmagnetische Matrix mit eingelagerten permanentmagnetischen Partikel, oder ein Elektromagnet ist.

4. Kraftsensor (100) nach einem der Ansprüche 1 bis 3, **dadurch gekennzeichnet, dass** die zumindest eine Messeinrichtung als Messchip (300) mit zumindest einer, vorzugsweise zwei oder vier internen magnetischen Messstrecken (313) ausgebildet ist, wobei der Messchip (300) vorzugsweise auf einem elektrisch isolierenden Träger (310) angeordnet ist.

5. Kraftsensor (100) nach einem der Ansprüche 1 bis 4, **dadurch gekennzeichnet, dass** zusätzlich ein magnetischer Kompensationskreis (210) mit vorzugsweise zumindest einem weiteren Erregermagneten (220) vorgesehen ist.

6. Herstellungsverfahren für einen magnetischen Kraftsensor (100) mit zumindest einer Leiterbahn (111, 211) aus weichmagnetischem Material, wobei die zumindest eine Leiterbahn (111, 211) zumindest eine Unterbrechung (130) mit einem Abstand (A) aufweist, wobei zumindest eine Messeinrichtung zur Überwachung des magnetischen Flusses innerhalb der zumindest einen Leiterbahn (111, 211) vorgesehen ist, wobei der Kraftsensor (100) auf einem Substrat, insbesondere einem zu überwachenden Bauteil (1, 2) angeordnet ist und eine Änderung des Abstands (A) anhand einer Änderung des magnetischen Flusses in der zumindest einen magnetischen Leiterbahn (111, 211) überwacht ist, nach einem der Ansprüche 1 bis 5, **dadurch gekennzeichnet, dass** auf einem Substrat, vorzugsweise auf einem zu überwachenden Bauteil (1, 2), zumindest eine magnetische Leiterbahn (111, 211) mit zumindest einer Unterbrechung (130) mit einem Abstand (A) aufgebracht wird, wobei die Aufbringung mittels galvanischer Abscheidung erfolgt.

7. Herstellungsverfahren nach Anspruch 6, **dadurch gekennzeichnet, dass** die zumindest eine magnetische Leiterbahn (111, 211) aus einer weichmagnetischen Legierung, beispielsweise aus einer Nickel-Eisen-Legierung besteht.

8. Herstellungsverfahren nach Anspruch 6 oder 7, **dadurch gekennzeichnet, dass** vor der Aufbringung der zumindest einen Leiterbahn (111, 211) eine nichtmagnetische Schicht (10) auf das Grundmaterial, insbesondere auf den zu überwachenden Bauteil (1, 2) aufgebracht wird, die vorzugsweise aus der Gruppe ausgewählt ist, die Kupfer, Zinn, Zink oder eine Legierung aus zwei oder mehr dieser Elemente oder eine nichtmagnetische Legierung von Eisenmetallen mit Phosphor enthält.

9. Herstellungsverfahren nach einem der Ansprüche 6 bis 8, **dadurch gekennzeichnet, dass** ein Erregermagnet (120, 220) mittels galvanischer Abscheidung auf das Substrat aufgebracht wird.

10. Herstellungsverfahren nach Anspruch 9, **dadurch gekennzeichnet, dass** eine permanentmagnetische Legierung, die aus einer Gruppe ausgewählt ist, die Legierungen wie Kobalt-Nickel-Phosphor, Kobalt-Nickel-Mangan-Phosphor, Kobalt-Nickel-Rhenium-Phosphor, Eisen-Platin, Kobalt-Platin und Bismut-Mangan enthält, galvanisch auf dem Substrat abgeschieden wird.

11. Herstellungsverfahren nach Anspruch 10, **dadurch gekennzeichnet, dass** in eine nichtmagnetische, metallische Matrix während der galvanischen Abscheidung auf dem Substrat permanentmagnetische Mikro- oder Nanopartikel eingebaut werden.

## Claims

1. A magnetic force sensor (100) having at least one conducting track (111, 211) of soft magnetic material, wherein the at least one conducting track (111, 211) has at least one interruption (130) having a distance (A), with at least one measuring device for monitoring the magnetic flux within the at least one conducting track (111, 211) being provided, wherein the force sensor (100) is arranged on a substrate, in particular on a component (1, 2) to be monitored, and a change in the distance (A) is monitored by way of a change in the magnetic flux within the at least one magnetic conducting track (111, 211), **characterized in that** at least one magnetic conducting track (111, 211) is applied to a substrate, preferably to a component (1, 2) to be monitored, and the at least one magnetic conducting track (111) with the at least one interruption (130) and the at least one measuring device form a magnetic measuring circuit (110), wherein at least one excitation magnet (120, 220) is provided, the at least one excitation magnet (120) being formed as part of the magnetic measuring circuit (110).

2. A force sensor (100) according to claim 1, **characterized in that** a magnetic barrier layer (10) of non-magnetic material is provided.

3. A force sensor (100) according to claim 1 or 2, **characterized in that** at least one excitation magnet (120, 220) is provided which is a permanent magnet made, for example, of a hard magnetic alloy or a non-magnetic matrix with incorporated permanently magnetic particles, or an electromagnet.

4. A force sensor (100) according to any of claims 1 to 3, characterized that the at least one measuring device is designed as a measuring chip (300) with at least one, preferably two or four, internal magnetic measuring sections (313), the measuring chip (300) preferably being arranged on an electrically insulating carrier (310).

5. A force sensor (100) according to any of claims 1 to 4, **characterized in that** a magnetic compensation circuit (210) preferably with at least one further excitation magnet (220) is additionally provided.

6. A manufacturing method for a magnetic force sensor (100) comprising at least one conducting track (111, 211) of soft magnetic material, wherein the at least one conducting track (111, 211) has at least one interruption (130) with a distance (A), with at least one measuring device for monitoring the magnetic flux within the at least one conducting track (111, 211) being provided, wherein the force sensor (100) is arranged on a substrate, in particular on a component (1, 2) to be monitored, and a change in the distance (A) is monitored by way of a change in the magnetic flux within the at least one magnetic conducting track (111, 211), according to any of claims 1 to 5, **characterized in that** at least one magnetic conducting track (111, 211) having at least one interruption (130) is applied to a substrate, preferably to a component (1, 2) to be monitored, involving a distance (A), wherein the application is effected by means of electrodeposition.

7. A manufacturing method according to claim 6, **characterized in that** the at least one magnetic conducting track (111, 211) consists of a soft magnetic alloy, for example, a nickel-iron alloy.

8. A manufacturing method according to claim 6 or 7, **characterized in that**, prior to the application of the at least one conducting track (111, 211), a non-magnetic layer (10) is applied to the base material, in particular to the component (1, 2) to be monitored, which layer is preferably selected from the group comprising copper, tin, zinc or an alloy of two or more of those elements or a non-magnetic alloy of iron metals with phosphorus.

9. A manufacturing method according to any of claims 6 to 8, **characterized in that** an excitation magnet (120, 220) is applied to the substrate by means of electrodeposition.

10. A manufacturing method according to claim 9, **characterized in that** a permanently magnetic alloy selected from a group comprising alloys such as cobalt-nickel-phosphorus, cobalt-nickel-manganese-phosphorus, cobalt-nickel-rhenium-phosphorus, iron-platinum, cobalt-platinum and bismuth-manganese, is electrodeposited on the substrate.

11. A manufacturing method according to claim 10, **characterized in that** permanently magnetic micro- or nanoparticles are incorporated into a non-magnetic, metallic matrix during the electrodeposition on the substrate.

## Revendications

1. Capteur de force magnétique (100) comprenant au moins une piste conductrice (111, 211) en matériau magnétique mou, dans lequel ladite au moins une piste conductrice (111, 211) présente au moins une discontinuité (130) sur une distance (A), dans lequel au moins un dispositif de mesure est prévu dans le but de surveiller le flux magnétique à l'intérieur de ladite au moins une piste conductrice (111, 211), dans lequel le capteur de force (100) est agencé sur un substrat, en particulier sur un composant à surveiller (1, 2), et dans lequel une variation de la distance (A) est surveillée à l'aide d'une variation du flux magnétique dans ladite au moins une piste conductrice magnétique (111, 211), **caractérisé en ce qu'**au moins une piste conductrice magnétique (111, 211) est appliquée sur un substrat, de préférence sur un composant à surveiller (1, 2), et **en ce que** ladite au moins une piste conductrice (111) magnétique qui présente ladite au moins une discontinuité (130) et ledit au moins un dispositif de mesure forment un circuit de mesure magnétique (110), dans lequel au moins un aimant d'excitation (120, 220) est prévu, ledit au moins un aimant d'excitation (120) se présentant sous la forme d'une partie du circuit de mesure magnétique (110).

2. Capteur de force (100) selon la revendication 1, **caractérisé en ce qu'**une couche faisant barrière magnétique (10) en matériau non magnétique est prévue.

3. Capteur de force (100) selon la revendication 1 ou 2, **caractérisé en ce qu'**au moins un aimant d'excitation (120, 220) est prévu, ledit aimant d'excitation étant un aimant permanent, par exemple, en alliage magnétique dur, ou une matrice non magnétique dans laquelle des particules magnétiques permanentes sont incorporées, ou un électroaimant.

4. Capteur de force (100) selon l'une quelconque des revendications 1 à 3, **caractérisé en ce que** ledit au moins un dispositif de mesure se présente sous la forme d'une puce de mesure (300) comprenant au moins un, de préférence, deux ou quatre tronçon(s) de mesure magnétique(s) interne(s) (313), la puce de mesure (300) étant agencée de préférence sur un support électriquement isolant (310).

5. Capteur de force (100) selon l'une quelconque des revendications 1 à 4, **caractérisé en ce qu'**un circuit de compensation magnétique (210) est en outre prévu et comprend de préférence au moins un autre aimant d'excitation (220).

6. Procédé de fabrication pour un capteur de force magnétique (100) comprenant au moins une piste conductrice (111, 211) en matériau magnétique mou, dans lequel ladite au moins une piste conductrice (111, 211) présente au moins une discontinuité (130) sur une distance (A), dans lequel au moins un dispositif de mesure est prévu dans le but de surveiller le flux magnétique à l'intérieur de ladite au moins une piste conductrice (111, 211), dans lequel le capteur de force (100) est agencé sur un substrat, en particulier sur un composant à surveiller (1, 2), et dans lequel une variation de la distance (A) est surveillée à l'aide d'une variation du flux magnétique dans ladite au moins une piste conductrice magnétique (111, 211) et, selon l'une quelconque des revendications 1 à 5, **caractérisé en ce qu'**au moins une piste conductrice magnétique (111, 211) qui présente au moins une discontinuité (130) sur une distance (A) est appliquée sur un substrat, de préférence sur un composant à surveiller (1, 2), l'application étant de préférence réalisée par l'intermédiaire d'un dépôt par voie galvanique.

7. Procédé de fabrication selon la revendication 6, **caractérisé en ce que** ladite au moins une piste conductrice magnétique (111, 211) est constituée d'un alliage magnétique mou, par exemple, d'un alliage de nickel-fer.

8. Procédé de fabrication selon la revendication 6 ou 7, **caractérisé en ce qu'**avant l'application de ladite au moins une piste conductrice (111, 211), une couche non magnétique (10) est appliquée sur le matériau de base, en particulier sur le composant à surveiller (1, 2), ladite couche non magnétique étant de préférence choisie dans le groupe comprenant le cuivre, l'étain, le zinc ou un alliage de deux ou plus de deux de ces éléments ou un alliage non magnétique de métaux ferreux avec du phosphore.

9. Procédé de fabrication selon l'une quelconque des revendications 6 à 8, **caractérisé en ce que** ledit au moins un aimant d'excitation (120, 220) est appliqué sur le substrat par l'intermédiaire d'un dépôt par voie galvanique.

10. Procédé de fabrication selon la revendication 9, **caractérisé en ce qu'**un alliage magnétique permanent, qui est choisi dans un groupe comprenant des alliages de type cobalt-nickel-phosphore, cobalt-nickel-manganèse-phosphore, cobalt-nickelrhénium-phosphore, fer-platine, cobalt-platine et bismuth-manganèse, est déposé par voie galvanique sur le substrat.

11. Procédé de fabrication selon la revendication 10, **caractérisé en ce que** des microparticules ou des nanoparticules magnétiques permanentes sont incorporées dans une matrice métallique non magnétique pendant le dépôt par voie galvanique sur le substrat.
